(19) Europäisches Patentamt
European Patent Office
Office européen des brevets

(11) **EP 3 894 956 B1**

(12) **EUROPEAN PATENT SPECIFICATION**

(45) Date of publication and mention
of the grant of the patent:
**13.08.2025 Bulletin 2025/33**

(21) Application number: **19836292.3**

(22) Date of filing: **11.12.2019**

(51) International Patent Classification (IPC):
**G03F 7/00** *(2006.01)*      **G03F 7/20** *(2006.01)*

(52) Cooperative Patent Classification (CPC):
**G03F 7/0002; G03F 7/202**

(86) International application number:
**PCT/US2019/065725**

(87) International publication number:
**WO 2020/123650 (18.06.2020 Gazette 2020/25)**

(54) **FLEXOGRAPHIC PRINTING FORM PRECURSOR AND A METHOD FOR MAKING THE PRECURSOR**

FLEXODRUCKFORMVORLÄUFER UND VERFAHREN ZUR HERSTELLUNG DES VORLÄUFERS

PRÉCURSEUR DE FORME D'IMPRESSION FLEXOGRAPHIQUE ET PROCÉDÉ DE FABRICATION DU PRÉCURSEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.12.2018 US 201862778007 P**

(43) Date of publication of application:
**20.10.2021 Bulletin 2021/42**

(73) Proprietor: **DuPont Electronics, Inc.**
**Wilmington, DE 19805 (US)**

(72) Inventors:
• **BLOMQUIST, Robert M.**
**River Edge, New Jersey 07661 (US)**
• **LUNGU, Adrian**
**Old Bridge, New Jersey 08857 (US)**

(74) Representative: **Dehns**
**10 Old Bailey**
**London EC4M 7NG (GB)**

(56) References cited:
**US-A1- 2016 154 308     US-A1- 2016 355 004**

**Description**

BACKGROUND OF THE INVENTION

This invention pertains to a photosensitive element, particularly to a photosensitive element that is a printing form precursor useful for forming a printing form suitable for relief printing.

Flexographic printing plates are widely used for printing of packaging materials ranging from corrugated carton boxes to cardboard boxes and to continuous web of plastic films. Flexographic printing plates are used in relief printing in which ink is carried from a raised-image surface and transferred to a substrate. Flexographic printing plates can be prepared from photopolymerizable compositions, such as those described in U.S. Patents 4,323,637 and 4,427,759. Photosensitive elements generally have a solid layer of the photopolymerizable composition interposed between a support and a coversheet or a multilayer cover element. Photopolymerizable elements are characterized by their ability to crosslink or cure upon exposure to actinic radiation.

Photopolymerizable elements undergo a multi-step process to be converted to a flexographic relief printing form. The photopolymerizable element is imagewise exposed with actinic radiation through an image-bearing art-work, such as a photographic negative, transparency, or phototool (e.g., silver halide films) for so called analog workflow, or through an in-situ mask having radiation opaque areas that had been previously formed above the photopolymerizable layer for so called digital workflow. The actinic radiation exposure is typically conducted with ultraviolet (UV) radiation. The actinic radiation enters the photosensitive element through the clear areas and is blocked from entering the black or opaque areas of the transparency or in-situ mask. The areas of the photopolymerizable layer that were exposed to the actinic radiation crosslink and harden; and, the areas of the photopolymerizable layer that were unexposed, i.e., areas that were under the opaque regions of the transparency or the in-situ mask during exposure, are not cross-linked or hardened, and are removed by treating with a washout solution or with heat leaving a relief image suitable for printing. After all desired processing steps, the printing form is then mounted on a cylinder and used for printing.

Analog workflows involve making an intermediate, i.e., the photographic negative, transparency, or phototool. Preparation of a phototool, such as from a silver halide film, is a complicated, costly and time-consuming process that can require separate processing equipment and chemical development solutions. Alternatively, a phototool can also be prepared from thermal imaging films, or by inkjet methods. Also, quality issues can arise with the use of phototool since the phototool may change slightly in dimension due to changes in temperature and humidity, and all surfaces of the phototool and the photopolymer plate should be clean and free of dust and dirt. The presence of such foreign matter can cause lack of intimate contact between the phototool and plate as well as image artifacts.

An alternative to analog workflow is termed digital workflow, which does not require the preparation of a separate phototool. Photosensitive elements suitable for use as the precursor and processes capable of forming an in-situ mask in digital workflow are described in U.S. Patents 5,262,275; U.S. 5,719,009; U.S. 5,607,814; U.S. 6,238,837; U.S. 6,558,876; U.S. 6,929,898; U.S. 6,673,509; U.S. 6,037,102; and U.S. 6,284,431. The precursor or an assemblage with the precursor includes a layer sensitive to laser radiation, typically infrared laser radiation, and opaque to actinic radiation. The infrared-sensitive layer is imagewise exposed with laser radiation of a digital imager unit whereby the infrared-sensitive material is removed from, or transferred onto/from a superposed film of the assemblage, to form the in-situ mask having radiation opaque areas and clear areas adjacent the photopolymerizable layer. Conventionally, the precursor is exposed through the in-situ mask to actinic radiation in the presence of atmospheric oxygen (since no vacuum is needed). Due in part to the presence of atmospheric oxygen during imagewise exposure, the flexographic printing form has a relief structure that is different from the relief structure formed in analog workflow (based upon the same size mask openings in both workflows). Digital workflow creates a raised element (i.e., dot or line) in the relief structure having a surface area of its uppermost surface (i.e., printing surface) that is significantly less than the opening in the in-situ mask corresponding to the relief structure, depending on the specific precursor chemistry and actinic radiation irradiance. Digital workflow results in the relief image having a different structure for raised elements that print small dots (i.e., raised surface elements) that is typically smaller, with a rounded top, and a curved sidewall profile, often referred to as dot sharpening effect. Dots produced by analog workflow are typically conical and have a flat-top. The relief structure formed by digital workflow results in positive printing properties such as, finer printed highlight dots fading into white, increased range of printable tones, and sharp linework. As such, the digital workflow because of its ease of use and desirable print performance has gained wide acceptance as a desired method by which to produce the flexographic printing form. But not all end-use applications view this dot-sharpening effect as beneficial.

It is known by those skilled in the art that the presence of oxygen ($O_2$) during exposure in free-radical photopolymerization processes will induce a side reaction in which the free radical molecules react with the oxygen, while the primary reaction between reactive monomer molecules occurs. This side reaction is known as inhibition (i.e., oxygen inhibition) as it slows down the polymerization or formation of crosslinked molecules. Many prior disclosures acknowledge that it is desirable for photopolymerization exposure to actinic radiation to occur in air (as is the case for digital workflow), under vacuum (as is the case for analog workflow), or in an inert environment. As disclosed in US Patent 8,241,835, conventional digital workflow has been modified in which imagewise exposure of a precursor occurs in an environment having an inert gas and a concentration of oxygen less than atmospheric oxygen but greater than a completely inert gas environment, i.e., the concentration of oxygen is between 190,000 parts per million (ppm) and 100 ppm. The modified digital workflow provides ease of use of digital workflow while avoiding the dot-sharpening effect of the relief features associated with conventional digital workflow to create relief features having an analog-like appearance.

Additionally, it is often desirable for the flexographic relief printing form to print images, particularly solid areas, with uniform, dense coverage of ink, so-called solid ink density. Poor transfer or laydown of ink from the printing form to the substrate, especially in large areas, results in print defects, such as mottle and graininess. Unsatisfactory printing results are especially obtained with solvent-based printing inks, and with UV-curable printing inks.

There are a number of ways to try and improve the ink density in solid areas of an image printed by a flexographic relief printing form. One way to improve solid ink density is to increase the physical impression between the printing form and the substrate. While this will increase solid ink density, the increased pressure will tend to deform smaller plate elements resulting in increased dot gain and loss of resolution. Another method of improving solid ink density involves increasing the surface area of the relief printing form, since a relief printing form with a roughened surface may hold and thus transfer to the substrate more ink than a smooth surface, and may result in a more uniform appearance. However, the surface roughness should be sufficient to increase ink transfer but not so much as to cause discreet features to directly print as this would result in undesirable artifacts in the final print. Typically a printing form that includes a matted layer and is prepared by analog workflow successfully retains the roughened surface, but in some instances there can be some loss of the fine structure of the roughened surface when prepared by conventional digital workflow because of the dot sharpening effect.

Solid screening is a well-known process for improving the solid ink density in flexographic printing. Solid screening consists of creating a pattern in the solid printing areas of the relief printing form which is small enough that the pattern is not reproduced in the printing process (i.e., printed image), and large enough that the pattern is substantially different from the normal, i.e., unscreened, printing surface. A pattern of small features that is used for solid screening is often referred to as a plate cell pattern or a microcell pattern.

GB 2 241 352 A discloses a process for preparing photopolymer plates having a plurality of well-like depressions by exposing the photopolymer layer to actinic radiation through a photographic mask containing optically transparent areas and optically opaque image areas, and a screen having a plurality of opaque discrete dots or other geometric shapes onto a photopolymer plate and developing the plate, to form a plurality of depressions in the relief planar surface of the exposed portions of the photopolymer layer.

Samworth in U.S. Patent 6,492,095 discloses a flexographic printing plate having solid image areas which are covered by a plurality of very small and shallow cells. The cells are created via a screened film halftone negative, an intermediate photomask, or via a top layer on the plate that is used as a mask.

Currently, various microcell patterns are widely used to improve the capability of relief printing forms to print solids with uniform, dense coverage of ink, i.e., solid ink density. The microcell patterns may be used in solid areas to improve printed ink density, as well as for text, line work, halftones, that is, any type of image element where an improvement in ink transfer characteristics is realized. In digital workflow, a microcell pattern is made into a digital file which is used by the digital imager unit to incorporate the pattern of microcells with the formation of the in-situ mask using laser radiation, usually infrared laser radiation. That is, the microcell pattern is formed from the infrared-sensitive layer that forms the in-situ mask. The microcell pattern is effectively superimposed in the digital file on image areas (often solids) where improved solid ink density is desired. Examples of patterns are small "negative" (blocking actinic radiation) features, e.g. a 96% halftone dot at 400 lines per inch, representing an array of approximately 14 micrometer (micron) diameter actinic radiation-blocking dots approximately 64 micrometers (microns) apart; and small "positive" (passing actinic radiation) features much closer together, e.g. a 12% halftone dot at 1400 lines per inch, representing an array of approximately 7 micrometers (micron) diameter actinic radiation-passing dots approximately 18 micrometers (microns) apart. In the latter example of small "positive" features, the effect of oxygen (dot sharpening) associated with conventional digital workflow can impact the ability to hold the microcell patterns in solid printing areas of the relief printing form. Typically, the finer the pattern of microcells, i.e. the smaller the size of each cell and closer the spacing of the cells, that is formed, the better the results. One problem with this method is that the additional cells increase the amount of time for laser imaging by the laser imager unit of the photosensitive element. In order to provide finer microcell patterns, companies that manufacture digital imager units have had to improve the optical resolution of their imagers and improve their imaging software as well. Both aspects substantially increase the cost of the imager and the time needed to image the photosensitive element.

Stolt et al. in US Patent Publication 2010/0143841 disclose a method to increase solid ink density printing capability for a relief printing form through digital patterning of image areas of the precursor. Stolt et al. disclose applying a pattern into a masking layer which is then laminated onto a photopolymer layer. After UV exposure and development, the pattern, which is smaller than the actual printable halftone image, provided an increase in printed solid ink densities. However, a customer will need to invest in a laminator. Certain loss of yield may occur. The imaging must be done at a higher resolution than normal, which requires more time.

Samworth et al. in US Patent No. 7,580,154 discloses printing plates containing ink cells in both sold and halftone areas. It is possible to laser image Samworth's digital flexographic plates. However, this method requires higher resolution imagers that add significant costs. A higher resolution imaging process also takes considerably longer time to finish.

Blomquist et al. in US Patent Application Publication No. 2016/0355004 discloses a preprinted layer on the masking layer to provide a microcell pattern built into the plate itself. While it is easy to use this method to achieve significant improvements in solid ink density, it is quite difficult to print a pattern with the desired resolution that can provide the maximum increase in solid ink density.

Fronczkiewicz et al. in US Patent Application Publication No. 2016/0154308 discloses a process of making a flexographic printing form with an additional embossing step in which the surface of the developed printing form is texturized by embossing to improve the print quality of the printing form.

A need exists for a relief printing form that can meet the increasing demands for print quality to improve the transfer of ink to printed substrate and to print, particularly solid areas, with uniform, dense coverage of ink. It is also desirable for the printing form to have a relief structure capable of printing a full tonal range including printing of fine print elements and highlight dots and thereby providing improved print quality. There is also a need for a method that is simple and relatively quick in preparing the relief printing form from a photosensitive printing form precursor, and yet can provide the printing form with a relief structure that improves transfer of ink to the substrate, without detrimental impact to dot gain and/or image resolution. It is desirable that the method utilizes a digital-like workflow for its ease and simplicity that results in the printing form having a relief structure with features necessary for high quality printing, without the additional expense to upgrade or purchase new digital imaging equipment and software, and without the loss in productivity, e.g., additional imaging time, for high resolution imaging in order to form microcell patterns.

## SUMMARY

An embodiment provides a printing form precursor comprising:

(a) a photopolymerizable layer comprising a first binder, a monomer, and a photoinitiator, wherein said photopolymerizable layer is supported by a support layer;
(b) an infrared ablation layer that is ablatable by infrared radiation and opaque to non-infrared actinic radiation, the infrared ablation layer comprising:

(i) at least one infrared absorbing material;
(ii) a radiation opaque material, wherein (i) and (ii) can be the same or different; and
(iii) at least one second binder;

wherein said infrared ablation layer is thermally embossed with a microcell pattern on the side facing the photopolymerizable layer; and
(c) a coversheet.

Another embodiment provides that the infrared ablation layer is thermally embossed with a microcell pattern, and is applied by lamination to a surface of the photopolymerizable layer that is opposite the support.

Another embodiment provides that the infrared ablation layer has a transmission optical density of greater than 2.0.

Another embodiment provides that the microcell pattern comprises a plurality of features wherein each feature has an area of between 5 to 750 square micrometers (microns).

Another embodiment provides that the first binder is different from the second binder.

Another embodiment provides a printing form precursor comprising:

(a) a photopolymerizable layer comprising a first binder, a monomer, and a photoinitiator, wherein said photopolymerizable layer is supported by a support layer;
(b) an infrared ablation layer that is ablatable by infrared radiation and opaque to non-infrared actinic radiation, the infrared ablation layer comprising:

(i) at least one infrared absorbing material; and
(ii) a radiation opaque material, wherein (i) and (ii) can be the same or different; and
(iii) at least one second binder;

wherein said an infrared ablation layer contains an overcoat/barrier layer which is thermally embossable on the side facing the photopolymerizable layer and is thermally embossed with a microcell pattern; and
(c) a coversheet.

Another embodiment provides a printing form precursor comprising:

(a) a coversheet:

(b) a release layer, wherein said release layer is thermally embossed with a microcell pattern on the side opposite the coversheet; and

(c) a photopolymerizable layer comprising a binder, a monomer, and a photoinitiator, wherein said photopolymerizable layer is between the release layer and a support layer.

Another embodiment provides a method of making a printing form precursor comprising:

a) providing a clear thermal polymer cover sheet;

b) providing an infrared ablation composition forming an infrared ablation layer on the cover sheet, the infrared ablation composition comprising (i) at least one infrared absorbing material; (ii) a radiation opaque material, wherein (i) and (ii) can be the same or different; and (iii) at least one second binder;

c) thermally embossing the infrared ablation layer with a microcell pattern on the side opposite the cover sheet; and

d) applying a photopolymerizable composition forming a photopolymerizable layer between the infrared ablation layer and a support layer, the photopolymerizable composition comprising a first binder, a monomer, and a photoinitiator.

Another embodiment provides a method of making a printing form precursor comprising:

a) providing a clear thermal polymer cover sheet;

b) applying an infrared ablation composition onto the cover sheet to form an infrared ablation layer, the infrared ablation composition comprising (i) at least one infrared absorbing material; (ii) a radiation opaque material, wherein (i) and (ii) can be the same or different; and (iii) at least one second binder;

c) applying an overcoat/barrier layer which is thermally embossable onto the infrared ablation layer;

d) thermally embossing the overcoat/barrier layer on the side opposite the cover sheet with a microcell pattern; and

e) applying a photopolymerizable composition forming a photopolymerizable layer between the overcoat/barrier layer and a support layer, the photopolymerizable composition comprising a first binder, a monomer, and a photoinitiator.

Another embodiment provides a method of making a printing form precursor comprising the steps of:

a) providing a clear thermal polymer cover sheet;

b) applying a release layer that is thermally embossable;

c) thermally embossing the release layer on the side opposite the cover sheet with a microcell pattern; and

d) applying a photopolymerizable composition forming a photopolymerizable layer between the release layer and a support layer, the photopolymerizable composition comprising a binder, a monomer, and a photoinitiator.

Yet another embodiment provides a method of making a printing form precursor comprising the steps of:

a) providing a clear thermal polymer cover sheet;

b) applying a release layer that is thermally embossable;

c) thermally embossing the release layer on the side opposite the cover sheet with a microcell pattern; and

d) applying a photopolymerizable composition forming a photopolymerizable layer between the release layer and a support layer, the photopolymerizable composition comprising a binder, a monomer, and a photoinitiator.

e) removing the coversheet; and

f) applying a mask on top of the release layer.

These and other features and advantages of the present invention will be more readily understood by those of ordinary skill in the art from a reading of the following Detailed Description. Certain features of the invention which are, for clarity, described above and below as a separate embodiment, may also be provided in combination in a single embodiment. Conversely, various features of the invention that are described in the context of a single embodiment, may also be provided separately or in any subcombination insofar as covered by the scope of the claims.

DETAIL DESCRIPTION

Throughout the following detailed description, similar reference characters refer to similar elements in all figures of the drawings.

Unless otherwise indicated, the following terms as used herein have the meaning as defined below.

"Actinic radiation" refers to radiation capable of initiating reaction or reactions to change the physical or chemical characteristics of a photosensitive composition.

"Lines per inch" (LPI) is a measurement of printing resolution in systems which use a halftone screen. It is a measure of how close together lines in a halftone grid are. Higher LPI generally indicates greater detail and sharpness to an image.

"Halftone" is used for the reproduction of continuous-tone images, by a screening process that converts the image into dots of various sizes and equal spacing between centers. A halftone screen enables the creation of shaded (or grey) areas in images that are printed by transferring (or non-transferring) of a printing medium, such as ink.

"Continuous tone" refers to an image that has a virtually unlimited range of color or shades of grays, that contains unbroken gradient tones having not been screened.

"Dots per inch" (DPI) is a frequency of dot structures in a tonal image, and is a measure of spatial printing dot density, and in particular the number of individual dots that can be placed within the span of one linear inch (2.54 cm). The DPI value tends to correlate with image resolution. Typical DPI range for graphics applications: 75 to 150, but can be as high as 300.

"Line screen resolution", which may sometimes be referred to as "screen ruling" is the number of lines or dots per inch on a halftone screen.

"Optical Density" or simply "Density" is the degree of darkness (light absorption or opacity) of an image, and can be determined from the following relationship:

$$\text{Density} = \log_{10}\{1 / \text{reflectance}\}$$

where reflectance is {intensity of reflected light / intensity of incident light}. Density is commonly calculated in conformance with ISO 5/3:2009 International Standard for Photography and graphic technology-- Density measurements - Part 3: Spectral conditions.

"Solid Ink Density" is a measure of the density of a printed area meant to display the maximum amount of print color.

"Graininess" refers to the variation in density of print areas. The ISO-13660 International Print Quality Standard defines it as, "Aperiodic fluctuations of density at a spatial frequency greater than 0.4 cycles per millimeter in all directions." The ISO-13660 metric of graininess is the standard deviation of density of a number of small areas that are 42 um square.

"Embossed microcell pattern" refers to a composite of features that together form a pattern for inclusion at some stage of production of the photosensitive element of the present invention. An embossed microcell pattern in which a plurality of features is incorporated into a photosensitive element is distinguished from a microcell pattern that is conventionally formed in a digital layer of a photosensitive element with infrared laser radiation by a digital imager device.

"Microcells" refer to image elements or microcells that alter a print surface, which can appear as dimples and/or very tiny reverses, and that are each smaller in at least one dimension than the spacing between smallest periodic structures on the printing form that results from the photosensitive element of the present invention. The microcells are irregularities on a print surface of the relief printing form that are designed to improve the uniformity and apparent density of ink printed on a substrate by the relief printing form. In some embodiments, microcells of the relief printing form can correspond with features of the printed microcell pattern that is integrated into the present photosensitive element.

"Microcell pattern" refers to a composite of image elements or microcells that together form a pattern that alters a print surface of a relief printing form which results from the photosensitive element of the present invention.

The term "pattern" is not limited in reference to "microcell pattern", and "printed microcell pattern", and, refers to placement of the individual features relative to one another, to include as a composite of the individual feature patterns that are random, pseudo-random, or regular, in one or two directions.

"Visible radiation or light" refers to a range of electromagnetic radiation that can be detected by the human eye, in which the range of wavelengths of radiation is between about 390 and about 770 nm.

"Infrared radiation or light" refers to wavelengths of radiation between about 770 and $10^6$ nm.

"Ultraviolet radiation or light" refers to wavelengths of radiation between about 10 and 390 nm.

Note that the provided ranges of wavelengths for infrared, visible, and ultraviolet are general guides and that there may be some overlap of radiation wavelengths between what is generally considered ultraviolet radiation and visible radiation, and between what is generally considered visible radiation and infrared radiation.

"White light" refers to light that contains all the wavelengths of visible light at approximately equal intensities, as in sunlight.

"Room light" refers to light that provides general illumination for a room. Room light may or may not contain all the wavelengths of visible light.

The term "photosensitive" encompasses any system in which the photosensitive composition is capable of initiating a reaction or reactions, particularly photochemical reactions, upon response to actinic radiation. Upon exposure to actinic radiation, chain propagated polymerization of a monomer and/or oligomer is induced by either a condensation mechanism or by free radical addition polymerization. While all photopolymerizable mechanisms are contemplated, the compositions and processes of this invention will be described in the context of free-radical initiated addition polymerization of monomers and/or oligomers having one or more terminal ethylenically unsaturated groups. In this context, the photoinitiator system when exposed to actinic radiation can act as a source of free radicals needed to initiate polymerization of the monomer and/or oligomer. The monomer may have non-terminal ethylenically unsaturated groups, and/or the composition may contain one or more other components, such as a binder or oligomer, that promote crosslinking. As such, the term "photopolymerizable" is intended to encompass systems that are photopolymerizable, photocrosslinkable, or both. As used herein, photopolymerization may also be referred to as curing. The photosensitive element may also be referred to herein as a photosensitive precursor, photosensitive printing precursor, printing precursor, and precursor.

As used herein, the term "solid" refers to the physical state of the photosensitive layer that has a definite volume and shape and resists forces that tend to alter its volume or shape. The layer of the photopolymerizable composition is solid at room temperature, which is a temperature between about 5° C and about 30°C. A solid layer of the photopolymerizable composition may be polymerized (photohardened), or unpolymerized, or both.

The term "digital layer" encompasses a layer that is responsive or alterable by laser radiation, particularly infrared laser radiation, and more particularly is ablatable by infrared laser radiation. The digital layer is also opaque to non-infrared actinic radiation. The digital layer may also be referred to herein as an infrared-sensitive layer, an infrared-sensitive ablation layer, a laser ablatable layer, or an actinic radiation opaque layer.

Unless otherwise indicated, the terms "photosensitive element", "printing form precursor", "printing precursor", and "printing form" encompass elements or structures in any form suitable as precursors for printing, including, but not limited to, flat sheets, plates, seamless continuous forms, cylindrical forms, plates-on-sleeves, and plates-on-carriers.

Photosensitive Element

The photosensitive element is a photopolymerizable printing form precursor. The photosensitive element includes a layer of a composition sensitive to actinic radiation which in most embodiments is a composition that is photopolymerizable. The photosensitive element includes a layer of the photosensitive composition and a digital layer adjacent to the photosensitive layer. The digital layer is employed in digital direct-to-plate image technology in which laser radiation, typically infrared laser radiation, is used to form a mask of the image for the photosensitive element (instead of the conventional image transparency or phototool). The digital layer comprises an infrared ablation layer that is ablatable by infrared radiation and opaque to non-infrared actinic radiation. The infrared ablation layer comprises (i) at least one infrared absorbing material; and (ii) a radiation opaque material, wherein (i) and (ii) can be the same or different. In one embodiment, the infrared ablation layer is thermally embossed with a microcell pattern on the side facing the photopolymerizable layer. In another embodiment where the infrared ablation layer contains an overcoat/barrier layer, the overcoat/barrier layer is thermally embossed with a microcell pattern on the side facing the photopolymerizable layer. In yet another embodiment for an analog process, a photosensitive element comprises a coversheet and a release layer between the coversheet and a photopolymerizable layer. The release layer is thermally embossed with a microcell pattern on the side opposite the coversheet. The coversheet is removed, and a mask is applied on top of the release layer before the photosensitive element is subject to UV exposure.

The microcell pattern includes a plurality of features in which each feature has an area between 5 to 750 square micrometers (microns). The microcell pattern is introduced by thermal embossing.

Thermal embossing is a common graphic arts technique used to impart a raised surface onto substrates. It is commonly used for embossing paper, foils and plastic films. It is capable of submicron resolution, and is commonly used to reproduce surface holograms.

Thermal embossing begins by using a master image, which has a raised pattern matching the desired pattern in the final product. This master can be either flat or round, with the latter being used for high speed roll-to-roll applications. These masters can be anything with a raised surface. One common method of making a master involves either mechanical or laser etching methods. These masters can also be made by a photolithographic process as is commonly done in the case of holograms.

Advantages of the present photosensitive element having an embossed microcell pattern layer integral to the photosensitive element include that it saves the end-user time and can increase productivity in the preparation of a printing form from the photosensitive element. The presence of the embossed microcell pattern avoids the need for end-users to form a microcell pattern in the digital layer with a digital imager device, and can increase productivity in the preparation of the printing form, because the mask can be formed in the digital layer by a low resolution digital imager device that is operated at high speed. Since the microcell pattern is pre-embossed at manufacture, end-users can avoid the need for a costly high resolution digital imager device with a substantial increase in imaging time to create a plate cell pattern and a mask from the digital layer. Furthermore, the relief printing form that results from the present photosensitive precursor advantageously meets the increasing demands for print quality to improve the transfer of ink to printed substrate and to print, particularly solid areas, with uniform, dense coverage of ink, and capable of printing a full tonal range including printing of fine print elements and highlight dots.

In some embodiments, the photosensitive element initially includes the digital layer disposed above and covers or substantially covers the entire surface of the photopolymerizable layer. In some embodiments, the infrared laser radiation imagewise removes, i.e., ablates or vaporizes, the digital layer to form the in-situ mask. Suitable materials and structures for this actinic radiation opaque layer are disclosed by Fan in U.S. Patent 5,262,275; Fan in U.S. Patent 5,719,009; Fan in U.S. Patent 6,558,876; Fan in EP 0 741 330 A1; and Van Zoeren in U.S. Patents 5,506,086 and 5,705,310. A material capture sheet adjacent the digital layer may be present during laser exposure to capture the material of the digital layer as it is removed from the photosensitive element as disclosed by Van Zoeren in U.S. Patent 5,705,310. Only the portions of the digital layer that were not removed from the photosensitive element will remain on the element forming the in-situ mask.

Materials constituting the digital layer and structures incorporating the digital layer are not particularly limited, provided that the digital layer can be imagewise exposed to form the in-situ mask on or adjacent the photopolymerizable layer of the photosensitive element. The digital layer may substantially cover the surface or only cover an imageable portion of the photopolymerizable layer. The digital layer can be used with or without a barrier layer. If used with the barrier layer, the barrier layer is disposed between the photopolymerizable layer and the digital layer to minimize migration of materials between the photopolymerizable layer and the digital layer. Monomers and plasticizers can migrate over time if they are compatible with the materials in an adjacent layer, which can alter the laser radiation sensitivity of the digital layer or can cause smearing and tackifying of the digital layer after imaging. The digital layer is also sensitive to laser radiation that can selectively remove or transfer digital layer.

In some embodiments, the digital layer comprises a radiation-opaque material, an infrared-absorbing material, and an optional binder. Dark inorganic pigments, such as carbon black and graphite, mixtures of pigments, metals, and metal alloys generally function as both infrared-sensitive material and radiation-opaque material. The optional binder is a polymeric material which includes, but is not limited to, self-oxidizing polymers, non-self-oxidizing polymers, thermochemically decomposable polymers, polymers and copolymers of butadiene and isoprene with styrene and/or olefins, pyrolyzable polymers, amphoteric interpolymers, polyethylene wax, materials conventionally used as the release layer described above, and combinations thereof. The thickness of the digital layer should be in a range to optimize both sensitivity and opacity, which is generally from about 20 Angstroms to about 50 micrometers. The digital layer should have a transmission optical density of greater than 2.0 in order to effectively block actinic radiation and the polymerization of the underlying photopolymerizable layer.

The digital layer includes (i) at least one infrared absorbing material, (ii) a radiation opaque material, wherein (i) and (ii) can be the same or different, and at least one binder. The following materials are suitable as the binder for the digital layer and include, but not limited to, polyamides, polyethylene oxide, polypropylene oxide, ethylcellulose, hydroxyethyl cellulose, cellulose acetate butyrate, ethylene-propylene-diene terpolymers, copolymers of ethylene and vinyl acetate, copolymers of vinyl acetate and vinyl alcohol, copolymers of vinyl acetate and pyrrolidone, polyvinyl acetate, polyethylene wax, polyacetal, polybutyral, polyalkylene, polycarbonates, polyester elastomer, copolymers of vinyl chloride and vinyl acetate, copolymers of styrene and butadiene, copolymers of styrene and isoprene, thermoplastic block copolymers of styrene and butadiene, thermoplastic block copolymers of styrene and isoprene, polyisobutylene, polybutadiene, polycholorprene, butyl rubber, nitrile rubber, thermoplastic polyurethane elastomer, cyclic rubbers, copolymers of vinylacetate and (meth)acrylate, acrylonitrile-butadiene-styrene terpolymer, methacrylate-butadiene-styrene terpolymer, alkyl methacrylate polymer or copolymer, copolymers of styrene and maleic anhydride, copolymers of styrene and maleic anhydride partially esterified with alcohols, and combinations thereof. Preferred binders include polyamides, polyethylene oxide, polypropylene oxide, ethylcellulose, hydroxyethyl cellulose, cellulose acetate butyrate, ethylene-propylene-diene terpolymers, copolymers of ethylene and vinyl acetate, copolymers of vinyl acetate and vinyl alcohol, copolymers of vinyl acetate and pyrrolidone, polyvinyl acetate, polyethylene wax, polyacetal, polybutyral, polyalkylene, polycarbonates, cyclic rubber, copolymer of styrene and maleic anhydride, copolymer of styrene and maleic anhydride partially esterified with alcohol, polyester elastomers, and combinations thereof.

Materials suitable for use as the radiation opaque material and the infrared absorbing material include, but is not limited to, metals, metal alloys, pigments, carbon black, graphite and combinations thereof. Mixtures of pigments in which each pigment functions as the infrared absorbing material, or the radiation opaque material (or both) can be used with the binder. Dyes are also suitable as infrared absorbing agents. Examples of suitable dyes include poly(substituted)phthalocyanine compounds; cyanine dyes; squarylium dyes; chalcogenopyrloarylidene dyes; bis(chalcogenopyrylo)-polymethine dyes; oxyindolizine dyes; bis(aminoaryl)-polymethine dyes; merocyanine dyes; croconium dyes; metal thiolate dyes; and quinoid dyes. Preferred is carbon black, graphite, metal, and metal alloys that functions as both the infrared absorbing material and the radiation opaque material. The radiation opaque material and the infrared absorbing material may be in dispersion to facilitate handling and uniform distribution of the material.

The photopolymerizable layer is a solid layer formed of the composition comprising a binder, at least one ethylenically unsaturated compound, and a photoinitiator. The photoinitiator is sensitive to actinic radiation. Throughout this specification actinic radiation will include ultraviolet radiation and/or visible light. The solid layer of the photopolymerizable composition is treated with one or more solutions and/or heat to form a relief suitable for relief printing. As used herein, the term "solid" refers to the physical state of the layer which has a definite volume and shape and resists forces that tend to alter its volume or shape. A solid layer of the photopolymerizable composition may be polymerized (photohardened), or unpolymerized, or both. In some embodiments, the layer of the photopolymerizable composition is elastomeric. In one embodiment, the photosensitive element includes a layer of photopolymerizable composition composed at least of a binder, at least one ethylenically unsaturated compound, and a photoinitiator. In another embodiment, the layer of the photopolymerizable composition includes an elastomeric binder, at least one ethylenically unsaturated compound, and a photoinitiator. In some embodiments, the relief printing form is an elastomeric printing form (i.e., the photopolymerizable layer is an elastomeric layer).

The binder can be a single polymer or mixture of polymers. In some embodiments, the binder is an elastomeric binder. In other embodiments, the layer of the photopolymerizable composition is elastomeric. Binders include natural or synthetic polymers of conjugated diolefin hydrocarbons, including polyisoprene, 1,2-polybutadiene, 1,4-polybutadiene, butadiene/acrylonitrile, and diene/styrene thermoplastic-elastomeric block copolymers. Preferably, the elastomeric block copolymer of an A-B-A type block copolymer, where A represents a non-elastomeric block, preferably a vinyl polymer and most preferably polystyrene, and B represents an elastomeric block, preferably polybutadiene or polyisoprene. In some embodiments, the elastomeric A-B-A block copolymer binders can be poly(styrene/isoprene/styrene) block copolymers, poly(styrene/butadiene/styrene) block copolymers, and combinations thereof. The binder is present in an amount of about 10% to 90% by weight of the photosensitive composition. In some embodiments, the binder is present at about 40% to 85% by weight of the photosensitive composition.

Other suitable binders include acrylics; polyvinyl alcohol; polyvinyl cinnamate; polyamides; epoxies; polyimides; styrenic block copolymers; nitrile rubbers; nitrile elastomers; non-crosslinked polybutadiene; non-crosslinked polyisoprene; polyisobutylene and other butyl elastomers; polyalkyleneoxides; polyphosphazenes; elastomeric polymers and copolymers of acrylates and methacrylate; elastomeric polyurethanes and polyesters; elastomeric polymers and copolymers of olefins such as ethylene-propylene copolymers and non-crosslinked EPDM; elastomeric copolymers of vinyl acetate and its partially hydrogenated derivatives.

The photopolymerizable composition contains at least one compound capable of addition polymerization that is compatible with the binder to the extent that a clear, non-cloudy photosensitive layer is produced. The at least one compound capable of addition polymerization may also be referred to as a monomer and can be a single monomer or mixture of monomers. Monomers that can be used in the photopolymerizable composition are well known in the art and include, but are not limited to, addition-polymerization ethylenically unsaturated compounds with at least one terminal ethylenic group. Monomers can be appropriately selected by one skilled in the art to provide elastomeric property to the photopolymerizable composition. The at least one compound capable of addition polymerization (i.e., monomer) is present in at least an amount of 5%, typically 10 to 20%, by weight of the photopolymerizable composition.

The photoinitiator can be any single compound or combination of compounds which is sensitive to actinic radiation, generating free radicals which initiate the polymerization of the monomer or monomers without excessive termination. Any of the known classes of photoinitiators, particularly free radical photoinitiators may be used. Alternatively, the photoinitiator may be a mixture of compounds in which one of the compounds provides the free radicals when caused to do so by a sensitizer activated by radiation. In most embodiments, the photoinitiator for the main exposure (as well as post-exposure and backflash) is sensitive to visible or ultraviolet radiation, between 310 to 400 nm, and preferably 345 to 365 nm. Photoinitiators are generally present in amounts from 0.001% to 10.0% based on the weight of the photopolymerizable composition.

The photopolymerizable composition can contain other additives depending on the final properties desired. Additional additives to the photopolymerizable composition include sensitizers, plasticizers, rheology modifiers, thermal polymerization inhibitors, colorants, processing aids, antioxidants, antiozonants, dyes, and fillers.

The thickness of the photopolymerizable layer can vary over a wide range depending upon the type of printing plate desired, for example, from about 0.005 inches to about 0.250 inches or greater (about 0.013 cm to about 0.64 cm or greater). In some embodiments, the photopolymerizable layer has a thickness from about 0.005 inch to 0.0450 inch (0.013 cm to 0.114 cm). In some other embodiments, the photopolymerization layer has a thickness from about 0.020 inches to about 0.112 inches (about 0.05 cm to about 0.28 cm). In other embodiments, the photopolymerizable layer has a thickness from about 0.112 inches to about 0.250 inches or greater (0.28 cm to about 0.64 cm or greater). As is conventional in the art, manufacturers typically identify the printing precursors relative to the total thickness of the printing form on press, which includes the thickness of the support and the photopolymerizable layer. The thickness of the photopolymerizable layer for the printing form is typically less than the manufacturer's designated thickness since the thickness of the support is not included.

The photosensitive element can include one or more additional layers on or adjacent the photosensitive layer. In most embodiments the one or more additional layers are on a side of the photosensitive layer opposite the support. Examples of additional layers include, but are not limited to, a protective layer, a capping layer, an elastomeric layer, a barrier layer, and combinations thereof. The one or more additional layers can be removable, in whole or in part, during one of the steps to convert the element into a printing form, such as treating.

Optionally, the photosensitive element may include an elastomeric capping layer on the at least one photopolymerizable layer. The elastomeric capping layer is typically part of a multilayer cover element that becomes part of the photosensitive printing element during calendering of the photopolymerizable layer. Multilayer cover elements and compositions suitable as the elastomeric capping layer are disclosed in Gruetzmacher et al., U.S. 4,427,759 and U.S. 4,460,675. In some embodiments, the composition of the elastomeric capping layer includes an elastomeric binder, and optionally a monomer and photoinitiator and other additives, all of which can be the same or different than those used in the bulk photopolymerizable layer. Although the elastomeric capping layer may not necessarily contain photoreactive components, the layer ultimately becomes photosensitive when in contact with the underlying bulk photopolymerizable layer. As such, upon imagewise exposure to actinic radiation, the elastomeric capping layer has cured portions in which polymerization or crosslinking have occurred and uncured portions which remain unpolymerized, i.e., uncrosslinked. Treating causes the unpolymerized portions of the elastomeric capping layer to be removed along with the photopolymerizable layer in order to form the relief surface. The elastomeric capping layer that has been exposed to actinic radiation remains on the surface of the polymerized areas of the photopolymerizable layer and becomes the actual printing surface of the printing plate. In embodiments of the photosensitive element that include the elastomeric capping layer, the cell pattern layer is disposed between the elastomeric capping layer and the digital layer.

For some embodiments of photosensitive elements useful as relief printing forms, the surface of the photopolymerizable layer may be tacky and a release layer having a substantially non-tacky surface can be applied to the surface of the photopolymerizable layer. Such release layer can protect the surface of the photopolymerizable layer from being damaged during removal of an optional temporary coversheet or other digital mask element and can ensure that the photopolymerizable layer does not stick to the coversheet or other digital mask element. During image exposure, the release layer can prevent the digital element with the mask from binding with the photopolymerizable layer. The release layer is insensitive to actinic radiation. The release layer is also suitable as a first embodiment of the barrier layer which is optionally interposed between the photopolymerizable layer and the digital layer. The elastomeric capping layer may also function as a second embodiment of the barrier layer. Examples of suitable materials for the release layer are well known in the art, and include polyamides, polyvinyl alcohol, hydroxyalkyl cellulose, copolymers of ethylene and vinyl acetate, amphoteric interpolymers, and combinations thereof.

The photosensitive printing element may also include a temporary coversheet on top of an uppermost layer of the element, which may be removed prior to preparation of the printing form. One purpose of the coversheet is to protect the uppermost layer of the photosensitive printing element during storage and handling. Examples of suitable materials for the coversheet include thin films of polystyrene, polyethylene, polypropylene, polycarbonate, fluoropolymers, polyamide or polyesters, which can be subbed with release layers. The coversheet is preferably prepared from polyester, such as Mylar® polyethylene terephthalate film.

## Process to Make Photosensitive Element

The process of making the photosensitive element includes a step in which a microcell pattern is created by thermally embossing a microcell pattern onto a layer of the photosensitive element; or, onto a layer of a separate element or film that forms an assemblage with the photopolymerizable layer to form the photosensitive element. The microcell pattern is integrated into the photosensitive element at time of manufacture. In most embodiments, the microcell pattern is thermally embossed and incorporated as part of the digital layer and facing the photopolymerizable layer of the photosensitive element. In some embodiments, the microcell pattern is thermally embossed onto an overcoat/barrier layer adjacent the digital layer. The overcoat/barrier is thermally embossable and is embossed on the side facing the photopolymerizable layer. In some other embodiments, the microcell pattern is thermally embossed onto a release layer between a coversheet and a photopolymerizable layer with the microcell pattern on the side opposite the coversheet.

It is well within the skill of the practitioner in the art to make or manufacture a photosensitive element printing form precursor that includes a layer of the photopolymerizable composition formed by admixing the binder, monomer, photoinitiator, and other optional additives. Since in most embodiments, the cell pattern layer is applied by printing onto a surface of the digital layer that will be adjacent the photopolymerizable layer, the cell pattern layer should withstand and not be disturbed or destroyed by the elevated temperature/s that is typically used to manufacture the photopolymerizable printing form precursor. In most embodiments, the photopolymerizable mixture is formed into a hot melt, extruded, calendered at temperatures above room temperature to the desired thickness between two sheets, such as the support and the temporary coversheet having the digital layer, or between one flat sheet and a release roll. Alternately, the photopolymerizable material can be extruded and/or calendered to form a layer onto a temporary support and later laminated to the desired final support or to a digital coversheet. The printing form precursor can also be prepared by compounding the components in a suitable mixing device and then pressing the material into the desired shape in a suitable mold. The material is generally pressed between the support and the coversheet. The molding step can involve pressure and/or heat.

The photosensitive element includes at least one photopolymerizable layer that can be of a bi- or multilayer construction. Further, the photosensitive element may include an elastomeric capping layer on the at least one photopolymerizable layer. Multilayer cover elements and compositions suitable as the elastomeric capping layer are disclosed in Gruetzmacher et al., U.S. 4,427,759 and U.S. 4,460,675.

Cylindrically shaped photopolymerizable elements may be prepared by any suitable method. In one embodiment, the cylindrically shaped elements can be formed from a photopolymerizable printing plate that is wrapped on a carrier or cylindrical support, i.e., sleeve, and the ends of the plate mated to form the cylinder shape. The cylindrically shaped photopolymerizable element can also be prepared extrusion and calendering in-the-round according to the method and apparatus disclosed by Cushner et al. in U.S. Patent 5,798,019.

The photosensitive element can be manufactured in several ways, and sold in one embodiment as a printing form precursor having all requisite layers, i.e., the photopolymerizable layer, and the digital layer with embossed microcell pattern; or the photopolymerizable layer, the digital layer, and an overcoat/barrier layer between the digital layer and the photopolymerizable layer that is embossed with a microcell pattern on the side facing the polymerizable layer. Alternatively, the photosensitive element can sold as separate components, e.g., a coversheet, a release layer that is embossed with a microcell pattern on the side opposite the coversheet, and a photopolymerizable that is between the release layer and a support. These separate components are manipulated separately, but are assembled to form a photosensitive element prior to imagewise exposure of the photopolymerizable layer.

In one embodiment, a digital composition is coated onto a web of a polymeric film, such as polyester film, to form the digital layer on the film. A microcell pattern is thermally embossed continuously onto a side of the digital layer that is opposite the film, to form a digital coversheet. The features of the microcell pattern are embossed continuously so that the thermally embossed microcell pattern does not include seams, breaks, or segmentation of the pattern on the digital layer web. The photopolymerizable composition is extruded to form the photopolymerizable layer between a base support, e.g., polyester film, and the digital coversheet, wherein the side of the digital coversheet having the microcell pattern layer is contacted to the photopolymerizable layer opposite the support. Printing form precursors that include the base support, the photopolymerizable layer, the digital layer with an a thermally embossed microcell pattern, and the polymeric film as an optional coversheet can be cut to any finished size for sale to end-users.

In one other embodiment, a digital composition is coated onto a web of a polymeric film, such as polyester film, to form the digital layer on the film, which is then cut to specific size/s of sheets. A microcell pattern is thermally embossed onto the sheets on a side of the digital layer that is opposite the film, to form a digital coversheet. The digital coversheet can be laminated to a photopolymerizable layer to form a printing form precursor with the embossed microcell pattern contacting the photopolymerizable layer.

In one other embodiment, a polymeric film, such as polyester film, is thermally embossed with a microcell pattern to form a microcell pattern on the film: and a layer of a thermally imageable composition is applied on the film, on the side opposite the microcell pattern, to create a digital coversheet. The digital coversheet is laminated to a surface of a photopolymerizable layer to form a printing form precursor with the embossed microcell pattern contacting the photopolymerizable layer.

In yet another embodiment, a photopolymerizable layer is placed on a support that is a polymeric film, such as polyester film. A release layer is thermally embossed with a microcell pattern, and placed on the photopolymerizable layer with the side having the microcell pattern contacting the photopolymerizable layer. A coversheet is placed on top of the release layer to form a printing form precursor. The coversheet can be removed and replaced with a mask on top of the release layer during conversion of the printing form precursor to a relief printing form.

Those skilled in the art, having benefit of the teachings of the present invention as hereinabove set forth, can affect numerous modifications insofar as covered by the scope of the claims.

<u>EXAMPLES</u>

In the following examples, all percentages are by weight unless otherwise noted. CYREL® photopolymerizable printing plates, CYREL® exposure unit, and CYREL® processor are all available from The DuPont Company (Wilmington, DE).

Commercially available DPR® digital plate by DuPont™ were used to make printing plates in the following examples. The coversheet film of the digital plate can have special coatings on the PET as further described in the examples below. The original unembossed coversheet films were used, as is, to serve as a control. Embossment of the coversheet films was conducted using a random pattern obtained from a sheet of 3M 261X Lapping film with a 5-micrometer (micron) surface. The embossing was done on a PL238WF system, from Professional Laminating Systems, at 300°F at a speed of 6.5 inches per minute.
It was done with the rough surface of the lapping film in contact with the coated surface of the PET coversheet. The lapping film was removed immediately after lamination and discarded. Flexographic printing plate precursors were made by laminating this coversheet to a photopolymer using the same laminating system at the same temperature, but at a speed of 55 inches per minute. The laminated plate was then allowed to sit in an over at 60°C overnight.

The printing plate precursors were converted to relief printing plates in accordance with the Cyrel® Process-of-Use Manual. Analog plates were imaged using a clear negative to produce a large solid area. Digital plates were imaged on an Esko CDI Spark 2530 using an image that produced a large solid area suitable for measuring solid ink density. The relief printing plates were tested for printing solids onto a substrate. A Mark Andy 830 Printing Press and an Aquaverse Pro Cyan ink from Sun Chemical were employed. The ink density of the solid printed areas was measured using a Techkon SpectroJet scanning spectrophotometer-densitometer (from Techkon USA (Danvers, MA, U.S.A)).

Example 1

In this example, the coversheet film of a DPR® digital plate was used directly, without any additional coating, to produce a standard digital flexographic printing plate. The coversheet consists of a 2.5 micrometer (micron) thick ablatable layer coated on PET film. One sample of this coversheet film was used, as is, as a control. Another sample was embossed as described above. Flexographic printing plates incorporating these coversheet films were made and tested in printing. The one from unembossed sample had a solid ink density of 1.12, whereas the one from the embossed sample had a solid ink density of 1.23. This resulted in a noticeably visible improvement in the printed sample.

Example 2

In this example, a coversheet film of a DPR® digital plate was coated with an oxygen barrier of 10-micrometer (micron) in thickness. This barrier layer consisted of a polyamide resin. One sample of the modified coversheet film was used, as is, as a control to make a digital flexographic plate with a barrier layer to inhibit oxygen transfer to the plate during cure. This barrier layer helps produce flexographic plates with flat topped dots that are sometimes preferred during printing. Another sample of the modified coversheet film was embossed as described above. Flexographic printing plates incorporating these coversheet films were made and tested in printing. The one from the unembossed sample had a solid ink density of 1.12, whereas the one from the embossed sample had a solid ink density of 1.25. This resulted in a noticeably visible improvement in the printed sample.

Example 3

In this example, a commercially available flexo plate HORB® digital plate by DuPont™ was used to produce a standard analog flexographic printing plate. The coversheet film of the flexo plate had a release layer of 4.0 micrometer (micron) in thickness coated on a PET film. One sample of this coversheet film was used, as is, as a control. Another sample of the coversheet film had its release layer embossed as described above. Flexographic printing plates incorporating these coversheet films were made and tested in printing. The one from the unembossed sample had a solid ink density of 1.08, whereas the one from the embossed sample had a solid ink density of 1.20. This resulted in a noticeably visible improvement in the printed sample.

As shown in Example 1-3, a significant improvement in solid ink density was obtained by embossing the coating on a coversheet prior to making a flexographic printing plate. Further improvements in solid ink density can be made by optimizing the pattern used for embossing.

**Claims**

1. A printing form precursor comprising:

   (a) a photopolymerizable layer comprising a first binder, a monomer, and a photoinitiator, wherein said photopolymerizable layer is supported by a support layer;
   (b) an infrared ablation layer that is ablatable by infrared radiation and opaque to non-infrared actinic radiation, the infrared ablation layer comprising:

      (i) at least one infrared absorbing material;
      (ii) a radiation opaque material, wherein (i) and (ii) can be the same or different; and
      (iii) at least one second binder;

   wherein said infrared ablation layer is thermally embossed with a microcell pattern on the side facing the photopolymerizable layer; and
   (c) a coversheet.

2. The printing form precursor of claim 1, wherein said infrared ablation layer is applied by lamination to a surface of the photopolymerizable layer that is opposite the support.

3. The printing form precursor of claim 1, wherein said infrared ablation layer has a transmission optical density of greater than 2.0.

4. The printing form precursor of claim 1, wherein said microcell pattern comprises a plurality of features wherein each feature has an area of between 5 to 750 square micrometers (microns).

5. The printing form precursor of claim 1, wherein said first binder is different from said second binder.

6. A printing form precursor comprising:

   (a) a photopolymerizable layer comprising a first binder, a monomer, and a photoinitiator, wherein said photopolymerizable layer is supported by a support layer;
   (b) an infrared ablation layer that is ablatable by infrared radiation and opaque to non-infrared actinic radiation, the infrared ablation layer comprising:

(i) at least one infrared absorbing material; and
(ii) a radiation opaque material, wherein (i) and (ii) can be the same or different; and
(iii) at least one second binder;

(c) an overcoat/barrier layer which is thermally embossable on the side facing the photopolymerizable layer and is thermally embossed with a microcell pattern; and
(d) a coversheet.

7. A printing form precursor comprising:

(a) a coversheet:
(b) a release layer, wherein said release layer is thermally embossed with a microcell pattern on the side opposite the coversheet; and
(c) a photopolymerizable layer comprising a binder, a monomer, and a photoinitiator, wherein said photopolymerizable layer is between the release layer and a support layer.

8. A method of making a printing form precursor comprising:

a) providing a clear thermal polymer cover sheet;
b) providing an infrared ablation composition forming an infrared ablation layer on the cover sheet, the infrared ablation composition comprising (i) at least one infrared absorbing material; (ii) a radiation opaque material, wherein (i) and (ii) can be the same or different; and (iii) at least one second binder;
c) thermally embossing the infrared ablation layer with a microcell pattern on the side opposite the cover sheet; and
d) applying a photopolymerizable composition forming a photopolymerizable layer between the infrared ablation layer and a support layer, the photopolymerizable composition comprising a first binder, a monomer, and a photoinitiator.

9. A method of making a printing form precursor comprising:

a) providing a clear thermal polymer cover sheet;
b) applying an infrared ablation composition onto the cover sheet to form an infrared ablation layer, the infrared ablation composition comprising (i) at least one infrared absorbing material; (ii) a radiation opaque material, wherein (i) and (ii) can be the same or different; and (iii) at least one second binder;
c) applying an overcoat/barrier layer which is thermally embossable onto the infrared ablation layer;
d) thermally embossing the overcoat/barrier layer on the side opposite the cover sheet with a microcell pattern; and
e) applying a photopolymerizable composition forming a photopolymerizable layer between the overcoat/barrier layer and a support layer, the photopolymerizable composition comprising a first binder, a monomer, and a photoinitiator.

10. A method of making a printing form precursor comprising the steps of:

a) providing a clear thermal polymer cover sheet;
b) applying a release layer that is thermally embossable;
c) thermally embossing the release layer on the side opposite the cover sheet with a microcell pattern; and
d) applying a photopolymerizable composition forming a photopolymerizable layer between the release layer and a support layer, the photopolymerizable composition comprising a binder, a monomer, and a photoinitiator.

11. The method of Claim 9, further comprising the steps of:

e) removing the coversheet; and
f) applying a mask on top of the release layer.

**Patentansprüche**

1. Druckformvorläufer, umfassend:

(a) eine photopolymerisierbare Schicht, die ein erstes Bindemittel, ein Monomer und einen Photoinitiator umfasst, wobei die photopolymerisierbare Schicht von einer Trägerschicht getragen wird;
(b) eine Infrarot-Ablationsschicht, die durch Infrarotstrahlung abtragbar ist und für nicht-infrarote aktinische Strahlung undurchlässig ist, wobei die Infrarot-Ablationsschicht umfasst:

(i) mindestens ein infrarotabsorbierendes Material;
(ii) ein strahlungsundurchlässiges Material, wobei (i) und (ii) gleich oder unterschiedlich sein können; und
(iii) mindestens ein zweites Bindemittel;

wobei die Infrarot-Ablationsschicht auf der der photopolymerisierbaren Schicht zugewandten Seite thermisch mit einem Mikrozellenmuster geprägt ist; und

(c) eine Deckfolie.

2. Druckformvorläufer nach Anspruch 1, wobei die Infrarot-Ablationsschicht durch Laminieren auf eine Oberfläche der photopolymerisierbaren Schicht aufgebracht ist, die dem Träger gegenüberliegt.

3. Druckformvorläufer nach Anspruch 1, wobei die Infrarot-Ablationsschicht eine optische Transmissionsdichte von mehr als 2,0 aufweist.

4. Druckformvorläufer nach Anspruch 1, wobei das Mikrozellenmuster eine Vielzahl von Merkmalen umfasst, wobei jedes Merkmal eine Fläche zwischen 5 und 750 Quadratmikrometern (Mikron) aufweist.

5. Druckformvorläufer nach Anspruch 1, wobei das erste Bindemittel sich vom zweiten Bindemittel unterscheidet.

6. Druckformvorläufer, umfassend:

(a) eine photopolymerisierbare Schicht, die ein erstes Bindemittel, ein Monomer und einen Photoinitiator umfasst, wobei die photopolymerisierbare Schicht von einer Trägerschicht getragen wird;
(b) eine Infrarot-Ablationsschicht, die durch Infrarotstrahlung abtragbar ist und für nicht-infrarote aktinische Strahlung undurchlässig ist, wobei die Infrarot-Ablationsschicht umfasst:

(i) mindestens ein infrarotabsorbierendes Material; und
(ii) ein strahlungsundurchlässiges Material, wobei (i) und (ii) gleich oder unterschiedlich sein können; und
(iii) mindestens ein zweites Bindemittel;

(c) eine Überzug-/Sperrschicht, die auf der der photopolymerisierbaren Schicht zugewandten Seite thermisch prägefähig ist und thermisch mit einem Mikrozellenmuster geprägt ist; und
(d) eine Deckfolie.

7. Druckformvorläufer, umfassend:

(a) eine Deckfolie;
(b) eine Freigabeschicht, wobei die Freigabeschicht auf der der Deckfolie gegenüberliegenden Seite thermisch mit einem Mikrozellenmuster geprägt ist; und
(c) eine photopolymerisierbare Schicht, die ein Bindemittel, ein Monomer und einen Photoinitiator umfasst, wobei sich die photopolymerisierbare Schicht zwischen der Freigabeschicht und einer Trägerschicht befindet.

8. Verfahren zum Herstellen eines Druckformvorläufers, Folgendes umfassend:

a) Bereitstellen einer klaren thermischen Polymerdeckfolie;
b) Bereitstellen einer Infrarot-Ablationszusammensetzung, die eine Infrarot-Ablationsschicht auf der Deckfolie bildet, wobei die Infrarot-Ablationszusammensetzung (i) mindestens ein infrarotabsorbierendes Material; (ii) ein strahlungsundurchlässiges Material, wobei (i) und (ii) gleich oder unterschiedlich sein können; und (iii) mindestens ein zweites Bindemittel umfasst;
c) thermisches Prägen der Infrarot-Ablationsschicht mit einem Mikrozellenmuster auf der der Deckfolie gegenüberliegenden Seite; und
d) Aufbringen einer photopolymerisierbaren Zusammensetzung, die eine photopolymerisierbare Schicht zwischen der Infrarot-Ablationsschicht und einer Trägerschicht bildet, wobei die photopolymerisierbare Zusammensetzung ein erstes Bindemittel, ein Monomer und einen Photoinitiator umfasst.

9. Verfahren zum Herstellen eines Druckformvorläufers, Folgendes umfassend:

a) Bereitstellen einer klaren thermischen Polymerdeckfolie;
b) Aufbringen einer Infrarot-Ablationszusammensetzung auf die Deckfolie, um eine Infrarot-Ablationsschicht zu bilden, wobei die Infrarot-Ablationszusammensetzung (i) mindestens ein infrarotabsorbierendes Material; (ii) ein strahlungsundurchlässiges Material, wobei (i) und (ii) gleich oder unterschiedlich sein können; und (iii) mindestens ein zweites Bindemittel umfasst;
c) Aufbringen einer thermisch prägefähigen Überzug-/Sperrschicht auf die Infrarot-Ablationsschicht;
d) thermisches Prägen der Überzug-/Sperrschicht auf der der Deckfolie gegenüberliegenden Seite mit einem Mikrozellenmuster; und
e) Aufbringen einer photopolymerisierbaren Zusammensetzung, die eine photopolymerisierbare Schicht zwischen der Überzug-/Sperrschicht und einer Trägerschicht bildet, wobei die photopolymerisierbare Zusammensetzung ein erstes Bindemittel, ein Monomer und einen Photoinitiator umfasst.

10. Verfahren zum Herstellen eines Druckformvorläufers, das die folgenden Schritte umfasst:

a) Bereitstellen einer klaren thermischen Polymerdeckfolie;

b) Aufbringen einer thermisch prägefähigen Freigabeschicht;

c) thermisches Prägen der Freigabeschicht auf der der Deckfolie gegenüberliegenden Seite mit einem Mikrozellenmuster; und

d) Aufbringen einer photopolymerisierbaren Zusammensetzung, die eine photopolymerisierbare Schicht zwischen der Freigabeschicht und einer Trägerschicht bildet, wobei die photopolymerisierbare Zusammensetzung ein Bindemittel, ein Monomer und einen Photoinitiator umfasst.

11. Verfahren nach Anspruch 9, ferner umfassend die folgenden Schritte:

e) Entfernen der Deckfolie; und

f) Aufbringen einer Maske oben auf die Freigabeschicht.

**Revendications**

1. Précurseur de forme d'impression comprenant :

(a) une couche photopolymérisable comprenant un premier liant, un monomère et un photo-initiateur, dans lequel ladite couche photopolymérisable est supportée par une couche de support ;

(b) une couche d'ablation par infrarouges qui peut être ablatée par un rayonnement infrarouge et qui est opaque vis-à-vis d'un rayonnement actinique non infrarouge, la couche d'ablation par infrarouges comprenant :

(i) au moins un matériau absorbant les infrarouges ;

(ii) un matériau opaque vis-à-vis du rayonnement, dans lequel (i) et (ii) peuvent être les mêmes ou peuvent être différents ; et

(iii) au moins un second liant ;

dans lequel ladite couche d'ablation par infrarouges est estampée thermiquement à l'aide d'un motif microcellulaire sur le côté faisant face à la couche photopolymérisable ; et

(c) une feuille de recouvrement.

2. Précurseur de forme d'impression selon la revendication 1, dans lequel ladite couche d'ablation aux infrarouges est appliquée par stratification sur une surface de la couche photopolymérisable qui est opposée au support.

3. Précurseur de forme d'impression selon la revendication 1, dans lequel ladite couche d'ablation aux infrarouges présente une densité optique de transmission supérieure à 2,0.

4. Précurseur de forme d'impression selon la revendication 1, dans lequel ledit motif microcellulaire comprend une pluralité de caractéristiques, chaque caractéristique présentant une aire entre 5 et 750 micromètres (microns) carrés.

5. Précurseur de forme d'impression selon la revendication 1, dans lequel ledit premier liant est différent dudit second liant.

6. Précurseur de forme d'impression comprenant :

(a) une couche photopolymérisable comprenant un premier liant, un monomère et un photo-initiateur, dans lequel ladite couche photopolymérisable est supportée par une couche de support ;

(b) une couche d'ablation par infrarouges qui peut être ablatée par un rayonnement infrarouge et qui est opaque vis-à-vis d'un rayonnement actinique non infrarouge, la couche d'ablation par infrarouges comprenant :

(i) au moins un matériau absorbant les infrarouges ; et

(ii) un matériau opaque vis-à-vis du rayonnement, dans lequel (i) et (ii) peuvent être les mêmes ou peuvent être différents ; et

(iii) au moins un second liant ;

(c) une couche de revêtement/barrière qui peut être estampée thermiquement sur le côté faisant face à la couche photopolymérisable et qui est estampée thermiquement à l'aide d'un motif microcellulaire ; et

(d) une feuille de recouvrement.

7. Précurseur de forme d'impression comprenant :

(a) une feuille de recouvrement ;

(b) une couche de libération, dans lequel ladite couche de libération est estampée thermiquement à l'aide d'un motif microcellulaire sur le côté opposé à la feuille de recouvrement ; et

(c) une couche photopolymérisable comprenant un liant, un monomère et un photo-initiateur, dans lequel ladite couche photopolymérisable est située entre la couche de libération et une couche de support.

8. Procédé de fabrication d'un précurseur de forme d'impression comprenant :

a) la fourniture d'une feuille de recouvrement en polymère thermique transparent ;

b) la fourniture d'une composition d'ablation par infrarouges formant une couche d'ablation par infrarouges sur la feuille de recouvrement, la composition d'ablation par infrarouges comprenant (i) au moins un matériau absorbant les infrarouges, (ii) un matériau opaque vis-à-vis du rayonnement, dans lequel (i) et (ii) peuvent être les mêmes ou peuvent être différents ; et (iii) au moins un second liant ;

c) l'estampage thermique de la couche d'ablation par infrarouges à l'aide d'un motif microcellulaire sur le côté opposé à la feuille de recouvrement ; et

d) l'application d'une composition photopolymérisable formant une couche photopolymérisable entre la couche d'ablation par infrarouges et une couche de support, la composition photopolymérisable comprenant un premier liant, un monomère et un photo-initiateur.

9. Procédé de fabrication d'un précurseur de forme d'impression comprenant :

a) la fourniture d'une feuille de recouvrement en polymère thermique transparent ;

b) l'application d'une composition d'ablation par infrarouges sur la feuille de recouvrement pour former une couche d'ablation par infrarouges, la composition d'ablation par infrarouges comprenant (i) au moins un matériau absorbant les infrarouges ; (ii) un matériau opaque vis-à-vis du rayonnement, dans lequel (i) et (ii) peuvent être les mêmes ou peuvent être différents ; et (iii) au moins un second liant ;

c) l'application d'une couche de revêtement/barrière qui peut être estampée thermiquement sur la couche d'ablation par infrarouges ;

d) l'estampage thermique de la couche de revêtement/barrière sur le côté opposé à la feuille de recouvrement à l'aide d'un motif microcellulaire ; et

e) l'application d'une composition photopolymérisable formant une couche photopolymérisable entre la couche de revêtement/barrière et une couche de support, la composition photopolymérisable comprenant un premier liant, un monomère et un photo-initiateur.

10. Procédé de fabrication d'un précurseur de forme d'impression comprenant les étapes suivantes :

a) la fourniture d'une feuille de recouvrement en polymère thermique transparent ;

b) l'application d'une couche de libération qui peut être estampée thermiquement ;

c) l'estampage thermique de la couche de libération sur le côté opposé à la feuille de recouvrement à l'aide d'un motif microcellulaire ; et

d) l'application d'une composition photopolymérisable formant une couche photopolymérisable entre la couche de libération et une couche de support, la composition photopolymérisable comprenant un liant, un monomère et un photo-initiateur.

11. Procédé selon la revendication 9, comprenant en outre les étapes suivantes :

e) l'enlèvement de la feuille de recouvrement ; et
f) l'application d'un masque sur le sommet de la couche de libération.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4323637 A
- US 4427759 A
- US 5262275 A
- US 5719009 A
- US 5607814 A
- US 6238837 B
- US 6558876 B
- US 6929898 B
- US 6673509 B
- US 6037102 A
- US 6284431 B
- US 8241835 B

- GB 2241352 A
- US 6492095 B
- US 20100143841 A, Stolt
- US 7580154 B, Samworth
- US 20160355004, Blomquist
- US 20160154308, Fronczkiewicz
- EP 0741330 A1, Fan
- US 5506086 A, Van Zoeren
- US 5705310 A
- US 4460675 A
- US 5798019 A, Cushner